# EUROPEAN PATENT APPLICATION

(11) **EP 4 535 421 A1**
(43) Date of publication of application: **09.04.2025**
(21) Application number: 24201083.3
(22) Date of filing: 18.09.2024
(51) Int. Cl.: H01L 23/495, H01L 23/31, H01L 23/00, H01L 21/56

(54) **PACKAGED SEMICONDUCTOR DEVICE AND METHOD OF MAKING THEREOF**

(30) Priority: 28.09.2023 CN 202311279542
(71) Applicant: NXP USA, Inc., Austin, TX 78735 (US)
(72) Inventor: Ge, You, 5656AG Eindhoven (NL); Wang, Zhijie, 5656AG Eindhoven (NL); Lee, Yit Meng, 5656AG Eindhoven (NL)
(74) Representative: Hardingham, Christopher Mark

(57) **Abstract**

A packaged semiconductor device is disclosure having a first major package surface and a second major package surface and comprising: an encapsulated die having a plurality of die contact pads on a first major die surface thereof; a molding compound; and a plurality of exposed solder pads each comprising a flattened lower surface of wedge-bond wire; wherein the plurality of exposed solder pads are around a peripheral region of the second major package surface and spaced apart by the molding compound; and wherein the plurality of solder pads are electrically connected to the contact pads by at least one set of bond wires. Corresponding methods are also disclosed.

## Description

### Field

This disclosure relates to integrated circuit (IC) packaging. More particularly, this disclosure relates to a packaged semiconductor devices and a method of making thereof.

### Background

With the development of electronic industry, semiconductor devices are developing in directions of higher power, higher voltage and higher current.

Packages such as Enhanced Small Outline Integrated Circuit (ESOIC) package and Power Quad Flat No-Lead (PQFN) package generally adapt to very high current. However, in order to adapt to high current and high power, heavy aluminum wires are typically used for such packages, and the lead frames of the package are generally expensive: they may account for 50-60% of the cost of packaging materials. Reducing the cost of such packaging has become a big challenge.

### Summary

According to a first aspect of the present disclosure, there is provided a packaged semiconductor device having a first major package surface and a second major package surface and comprising: an encapsulated die having a plurality of die contact pads on a first major die surface thereof; a molding compound; and a plurality of exposed solder pads each comprising a flattened lower surface of wedge-bond stub; wherein the plurality of exposed solder pads are around a peripheral region of the second major package surface and spaced apart by the molding compound; and wherein the plurality of solder pads are electrically connected to the contact pads by at least one set of bond wires. The package thus does not require the use of a lead-frame. In particular, the die contact pads are not part of a lead-frame. Instead, they are formed by flattening wire, during a wedge-bond process: the wedge-bonds, resulting from the wedge-bonding process, include a section of flattened wire which forms the interface to the substrate following the wedge-bonding process. By performing the wedge-bonding at appropriate positions, and subsequent removal of the substrate, this flattened lower surface may be exposed. The flattened lower surface may then act as a contact pad or solder pad in the package.

In one or more embodiments, the package further comprises an exposed area of a conductive material in a central region of the second major package surface, electrically connected to a second die major surface, and spaced apart from the exposed solder pads by the molding compound. The conductive material may be an epoxy.

In one or more embodiments, the at least one set of bond wires comprises a first set of bond wires each of which is bonded at a first end to a respective contact pad, and each of which comprises the wedge-bond stub at a respective second end. Thus, a wedge-bond stub may be "stand-alone", in the sense of requiring a separate electrical connection, of a bond wire, to the die, or may be "integral" with a wire-bond electrical connection to the die, and form one end of such an electrical connection. Each of the first set of bond wires may comprise or consist of the wedge-bond wire. This may reduce process complexity, relative to embodiments in which different wires are used, since a separate wire-bonding process may not be required.

In one or more embodiments, either or both of the first set of bond wires and the wedge-bond wires may comprise aluminum wires. Aluminum wires may be relatively inexpensive, relatively malleable and/or may provide for relatively high currently densities.

In one or more embodiments, the at least one set of bond wires comprises a second set of bond wires each of which is bonded between a respective one of the plurality of contact pads and a respective opposing surface to one of the exposed contact pads. Such bond wires may be bonded to the opposing surface by known techniques such as ball-bonding, and may be thinner than the wedge-bond wire. This may reduce the bill of materials, and may further allow for a relatively high "pin-out" or packing density, and thus a greater number of electrical connections, relative to embodiments in which the bond wires all comprise the wedge-bond wire.

In one or more embodiments, the package further comprises at least one of a flux or a plating on a bottom surface of the exposed solder pads. Coating the exposed solder pads with a flux, or plated layer, may facilitate electrical connection to, for example, a circuit board on which the package is to be mounted.

In one or more embodiments, a length of each exposed solder pad is in a range between 0.3 and 0.8mm, and a width of each exposed solder pad is in a range between 0.2 and 0.4mm. In one or more embodiments, a diameter of each aluminum wire is in a range between 0.1 and 0.5mm. Such dimensions are suited to available production equipment, and the size of typical packaged devices. The disclosure is not, however, limited thereto.

According to a second aspect of the present disclosure, there is provided a method of manufacturing a packaged semiconductor device having a first major package surface and a second major package surface, the method comprising: providing a semiconductor die having a plurality of die contact pads on a first major die surface thereof; bonding a second major die surface of the semiconductor die to a substrate, providing a plurality of solder pads each formed of a flattened lower surface of a wedge-bond stub around and remote from the semiconductor die by forming wedge-bonds on the substrate; forming at least one set of electrical connections between the plurality of solder pads and the contact pads by a first set of bond wires; encapsulating the semiconductor die and wedge-bond stub; and removing the substrate, thereby exposing the solder pads on the second major package surface. The wedge-bonds may be formed directly on the substrate. The requirement to use a lead frame in the assembly process may thereby be avoided.

In one or more embodiments, the step of bonding a second major die surface of the semiconductor die to a substrate comprises bonding the second major die surface of the semiconductor die to a substrate by a conductive epoxy material, and the step of removing the substrate comprises exposing the conductive epoxy material on the second major package surface. Use of a conductive material, such as a conductive epoxy material, may be convenient, since it is commonly used in the semiconductor industry for bonding the semiconductor die to a lead frame. Subsequent removal of the substrate to expose the conductive material such as conductive epoxy material may allow for straightforward and low resistance electrical connection to the second surface of the die.

In one or more embodiments, forming at least one set of electrical connections between the plurality of solder pads and the contact pads comprising forming a plurality of wire bonds between respective ones of the plurality of contact pads, and a respective wedge-bond stub at an opposing flattened surface to the solder pad. Wire bonds between the semiconductor die and the wedge-bond stub acting as a contact to the exterior of the package may be convenient for providing low resistance electrical connection to the die from the exterior of the package.

In one or more embodiments forming at least one set of electrical connections comprises forming a plurality of wedge-bonds from the wedge-bond stub, between respective ones of the plurality of contact pads, and each of which comprises the wedge-bond stub at a respective second end. In such embodiments, the wire used to form the wedge-bond stub acting as the solder pad may be directly connected to the semiconductor die. In one or more embodiments each of the second set of bond wires comprises the wedge-bond stub. Since typically the wire for the solder pads is larger diameter than may be used for other wire bonds, use of this wire to provide the entirety of the electrical connection within the package to the die may provide for particularly low resistance electrical connection, such as may be appropriate for high-power devices.

In one or more embodiments the second set of bond wires comprises aluminum wires. Furthermore, the wedge-bond stub may comprise an aluminum wire. Aluminum may be a suitable material providing a good compromise between hardness, electrical conduction, and cost. However the present disclosure is not limited thereto.

In one or more embodiments, the method further comprises providing least one of a flux or a plating on a bottom surface of the exposed solder pads.

In one or more embodiments, a length of each exposed solder pad is in a range between 0.3 and 0.8mm, and a width of each exposed solder pad is in a range between 0.2 and 0.4mm. Furthermore, a diameter of each aluminum wire may be in a range between 0.1 and 0.5mm.

These and other aspects of the invention will be apparent from, and elucidated with reference to, the embodiments described hereinafter.

### Brief description of Drawings

Embodiments will be described, by way of example only, with reference to the drawings, in which
Fig. 1 shows a wedge-bond, which may also be referred to as an ultrasonic wedge-bond.;
FIG. 2 shows, pictorially, a process for producing a wedge-bond stub or wedge-bond wire;
Fig. 3A is a plan view and a cross-section of a substrate on a carrier, resulting in a sub-assembly;
FIG. 3B is a cross-sectional view of the substrate on the carrier;
FIG. 4A shows a plan view of a part assembled semiconductor package according to one or more embodiments of the present disclosure;
FIG. 4B shows a cross-section of a part-assembled semiconductor package according to one or more embodiments of the present disclosure;
FIG. 5A shows a plan view of a part-assembled semiconductor package according to one or more embodiments of the present disclosure, at a later stage of assembly;
FIG. 5B shows a cross-section of a part-assembled semiconductor package according to one or more embodiments of the present disclosure, at a later stage of assembly;
FIG. 6A shows a plan view of a part-assembled semiconductor package according to one or more embodiments of the present disclosure, at a still later stage of assembly;
FIG. 6B shows a cross-section of a part-assembled semiconductor package according to one or more embodiments of the present disclosure, at a still later stage of assembly;
FIG. 7 shows a cross-section of a part-assembled semiconductor package according to one or more embodiments of the present disclosure, at a yet later stage of assembly;
FIG. 8 shows a cross-section of a part-assembled semiconductor package according to one or more embodiments of the present disclosure, at a yet later stage of assembly;
FIG. 9 shows a cross-section of a part-assembled semiconductor package according to one or more embodiments of the present disclosure, at a yet later stage of assembly;
FIG. 10 shows a cut-away plan view of a package semiconductor device according to one or more embodiments;
FIG. 11 show a view of a second major surface of a package semiconductor device according to one or more embodiments; and
FIG. 12 shows a flowchart of a method according to one or more embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

Detailed illustrative embodiments of the present invention are disclosed herein. However, specific structural and functional details disclosed herein are merely representative for purposes of describing example embodiments of the present invention. The present invention may be embodied in many alternate forms and should not be construed as limited to only the embodiments set forth herein. Further, the terminology used herein is for the purpose of describing particular embodiments only and is not intended to be limiting of example embodiments of the invention.

As used herein, the singular forms "a," "an," and "the," are intended to include the plural forms as well, unless the context clearly indicates otherwise. It further will be understood that the terms "comprises," "comprising," "includes," and/or "including," specify the presence of stated features, steps, or components, but do not preclude the presence or addition of one or more other features, steps, or components. It also should be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

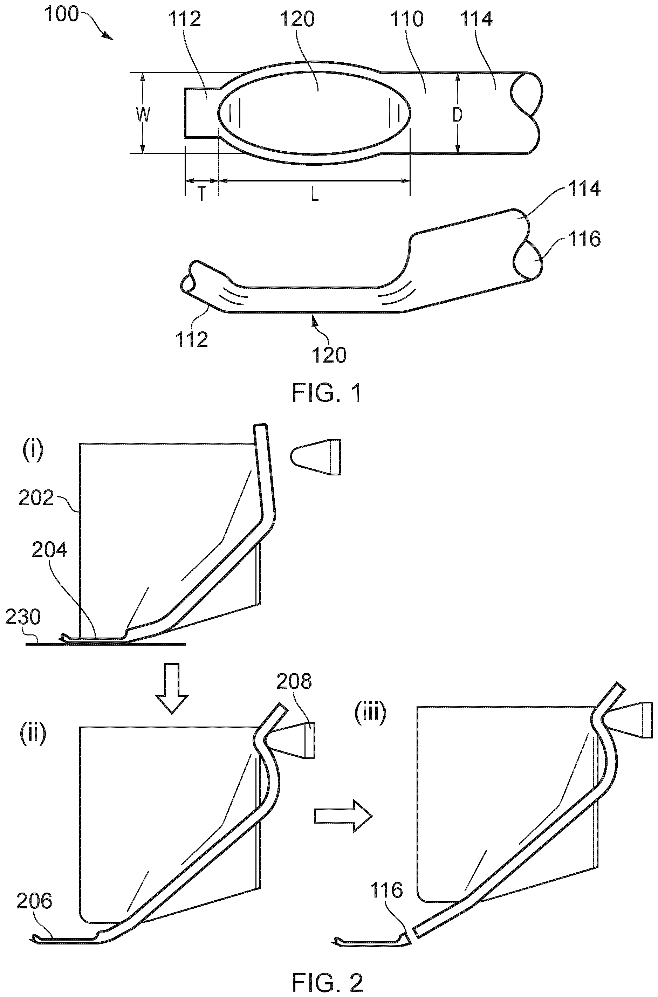

Referring now to FIG. 1, this shows a wedge-bond 100, which may also be referred to as an ultrasonic wedge-bond. As will be familiar to the skilled person, during a wedge-bonding process, pressure is applied to a wire material, typically with concurrent application of an ultrasonic vibration (at frequencies generally ranging between 40 and 125 kHz).. As a result of the application of pressure, the wire 110 which may have a starting diameter D as shown, is deformed over a length L, close to a tail end 112 of the wire having length T. The deformed section of wire has a flattened lower surface 120. As a result of the friction induced by the ultrasonic vibration, this lower surface is heated, and becomes bonded to a substrate material. The precise bonding mechanism - for instance whether the bonding is solid state or there is a local melting of material - depends on the combination of the wire and the substrate, and is not relevant to the scope of the present disclosure. However, the inventors have appreciated that this flattened lower surface of the wedge-bond stub may be utilised in packaged semiconductor devices in place of the contact pads usually provided by a lead frame. As a result, it may be possible to provide a packaged semiconductor device without using contact pads from a lead frame, or even without having a lead frame at all.

As will be described in more detail hereinbelow, in one or more embodiments the wedge-bond wire may extend beyond the wedge-bond stub itself and be used as some or all of the bond wires to a semiconductor chip embedded in the package. In other embodiments, the wedge-bond wire is not used as a bond wire to the semiconductor die. Rather, the wedge-bond stub is utilised solely as contact pads for the package. In such embodiments, it is necessary to provide such a wedge-bond stub which has only a short wire tail at one end and a short wire stump 114 at the other end. Such a stand-alone wedge-bond may be referred to as a "wedge-bond stub", "wedge-bond wire stub", or an "isolated wedge-bond" or simply as a "wire wedge-bond". FIG. 2 shows, pictorially, a process for producing such a wedge-bond stub. At step (i) a bonding tool 202 is lowered to apply pressure to an exposed part 204 of wire 110, such as aluminum wire, which is fed through the tool. At this stage the wire is not clamped to the tool. The wire is thereby flattened, leaving a short and flattened tail 206 and ultrasonic vibrations are applied to perform the bonding of the exposed, flattened wire to a substrate 230. The wire is then lifted, as shown at (ii) and the wire clamped to the tool as illustrated by the clamp 208. The tool is then moved laterally in order to stretch and ultimately breaks the wire at a breakpoint 116 where the wire was already stressed by the wedge-bonding process. The result is a stand-alone wedge-bond, bonded to the substrate. This structure may be identifiable and termed as a "wedge-bond stub". Its lower surface may be referred to as a "flattened wedge-bond wire". The structural features of this components may be readily identifiable, and thus the term "flattened wedge-bond wire" may refer, as used hereinunder, to the structure itself rather than to the process used to form the structure.

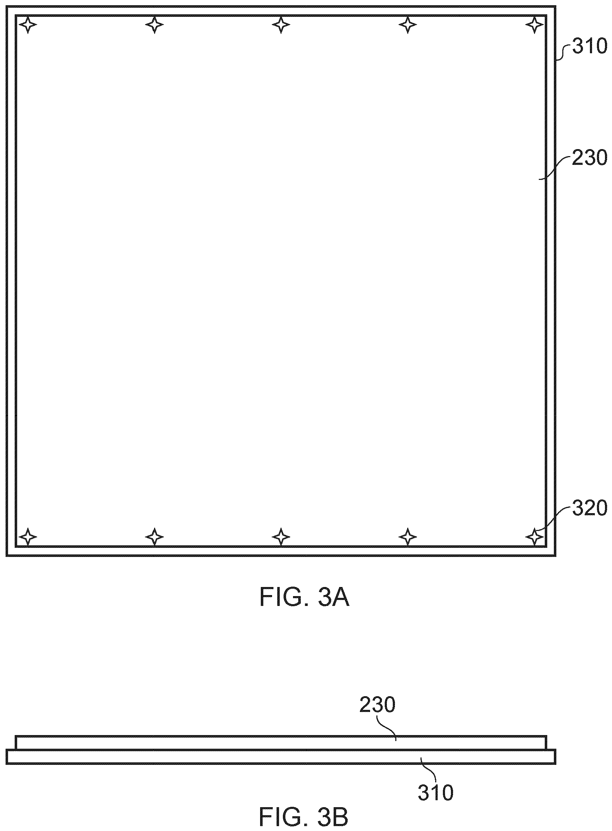

FIG. 3A and FIG. 3B show, respectively, a plan view and a cross-section of a substrate 230 on a carrier 310, resulting in a subassembly. The substrate 230 may be bonded to the carrier 310 by means of a glue or other adhesive. In one or more embodiments, the substrate 230 may be fixed on the carrier 310 using UV tape. The substrate 230 may be made of a suitable metal, such as copper, gold, silver, tin or other metals or alloys including at least one of these metals, as long as it can be welded or bonded to the wedge-bond stub which is typically aluminum. As will be discussed in more detail hereinbelow. The carrier 310 may be made of stainless steel, copper and other suitable material. The thickness of the substrate 230 may be 0.01-0.05mm. The upper ends and lower ends of the substrate 230 or the carrier 310 may provided with reference marks, or fiducial marks, 320, to assist in locating and positioning components throughout the assembly process. The reference marks can be used for indicating the distance. The reference marks 320 can thus be used for position alignment of elements (including die, bond pads etc), packaging separation and etching process. The size, locations, shape and so on of the reference marks 320 may be determined, according to the requirements of different die sizes and package sizes. They can be cross, square, triangle, star, or other suitable shape.

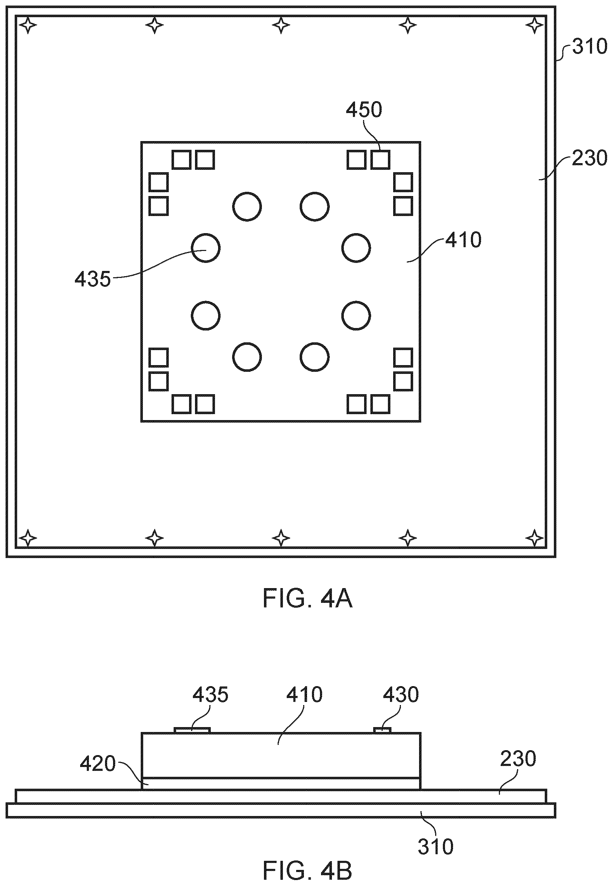

FIG. 4A and FIG. 4B show, respectively, a plan view and a cross-section of a part assembled semiconductor package according to one or more embodiments. A semiconductor die 410 is shown bonded to the substrate 230 by means of an electrically conductive material 420. The conductive material 420 may be, for instance, a conductive epoxy or a die attach film (DAF). The semiconductor die 410 includes, on its first major surface - which may be, as shown, the top surface - a plurality of die contact pads 430. The die contact pads 430 may be of uniform size and shape, or include a subset of larger, or differently-sized pads, shown in the FIG.s as 435.

Although FIG. 4A and FIG. 4B show a single semiconductor die 410 bonded to the substrate 230, the skilled person will appreciate that a plurality of die may be bonded to a suitably sized substrate. By such mechanism, a plurality of die may be co-packaged in the same package, or at least a part of the package assembly process may be carried out on a plurality of packages at the same time. Embodiments of the present disclosure are thus at least partly compatible with so-called wafer scale packaging.

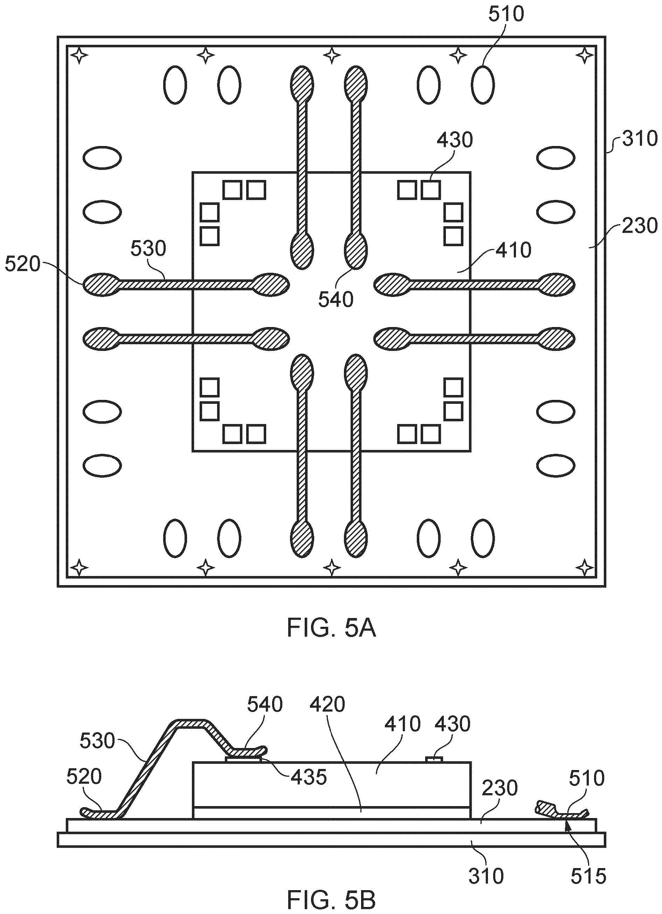

FIG. 5A and FIG. 5B show, respectively, a plan view and a cross-section of a part assembled semiconductor package according to one or more embodiments. As shown, a plurality of stand-alone wedge-bond sites 510, or flattened wedge-bonds, have been formed on the substrate 230. These wedge-bonds are around the peripheral region of the eventual package, which may be defined by fiducial marks as shown. The lower surface of the wedge-bonds, that is to say the flattened wedge-bond wire, is generally planar, and bonded to the substrate 230. These lower surfaces will, as will be described in more detail hereinbelow, form solder pads for the eventual package device. As is evident from FIG. 2, and illustrated in FIG. 5A, the general shape of the flattened wedge-bond wires is, approximately, an elongate ellipse, and may equivalently be considered to be a rectangle with rounded corners. The exact shape will depend on the length of the wedge tool relative to the diameter of the wire, and the degree to which the wire is deformed during the wedge-bond process. Typically, the wedge-bond wire 510 is aluminum, and a diameter of the aluminum wire may be 0.1-0.5mm. A length of each first wedge-bond 510 may typically be 0.3-0.8mm, and a width may be 0.2-0.4mm.

Also shown in FIG. 5A and FIG. 5B are further wedge-bond sites 520. These wedge-bond sites 520 do not form stand-alone wedge-bonds, rather they are formed at one end of a wire or bond wire 530 which provides electrical connection to the semiconductor die, the other end of the wire being bonded by conventional means typically by wedge bonding at a wedge-bond 540 since ball bonding is impractical for thicker wire: as the skilled person will be aware, forming a free air ball (FAB) is impractical for wires thicker than about 100µm These wedge bonds are made to a subset of the semiconductor die contact pads 435. It will be appreciated that using wire including wedge-bonds to the substrate, generally will involve larger diameter wire than is typical for wire bonding between the semiconductor die and a contact pad comprising part of a lead frame. The electrical connection provided by such bond wires 530 may be particularly suitable for high power and in particular high current devices. In one or more embodiments, all the electrical connections to the semiconductor die 410 are provided by wedge-bond wires 530. In such embodiments, there may be no requirement for any stand-alone wedge-bond wires 510.

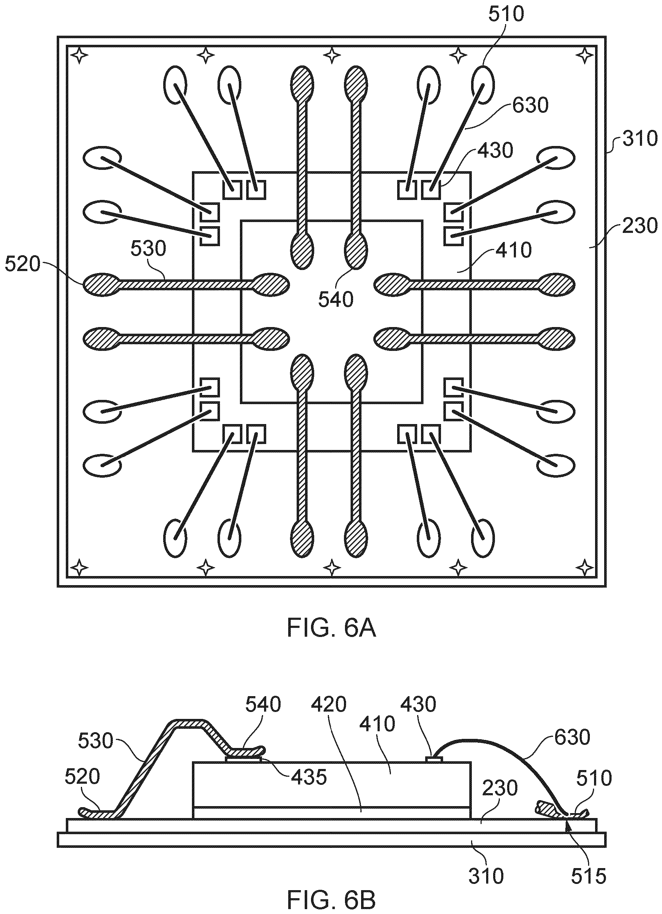

FIG. 6A and FIG. 6B show, respectively, a plan view and a cross-section of a part assembled semiconductor package according to one or more embodiments during a later stage of assembly. The first wedge-bonds 510 are electrically connected to die on the semiconductor die by means of a set of bond wires 630. Individual ones of these bond wires connect individual die contact pads 430 to the top surface of a respective stand-alone wedge-bond stub 510. At this stage of the assembly, this top surface is exposed; however, as will become clearer hereinunder, in the completed package, this top surface is encapsulated, and the bottom surface of the wedge-bond stub, which was flattened in the process of forming the wedge-bond to the substrate, will be exposed. The bond wire 630 is thus bonded to an opposing surface of one of the exposed contact pads, when considered from the perspective of the finalised device. In general, the bond wires may be of a different material than the wedge-bond wire. Moreover, since the bond wires may typically, although not exclusively, carry signals rather than high power their diameter may be smaller than that of the wedge-bond wire. Typically, the bond-wires may have a diameter which is in a range between 25 and 33 µm The bond wires may be bonded to the wedge-bond stub by known techniques such as ball bonding or wedge-bonding. Ball bonding is a preferred technique, since it is gerneally faster then wedge bonding. Furthermore, the first bond is typically made to the die contact pad, using a FAB, and hte second bond to the stand-alone wedge bond wire. The bond wires 630 may be made of any suitable material, which may include copper, gold, silver, tin or other metals or alloys including at least one of these metals

Embodiments of the present disclosure such as that shown part-processed and schematically in FIG. 6A and FIG. 6B may advantageously be able to provide high power electrical connection to the semiconductor die through relatively large diameter and low resistivity bond wires which are integral to the wedge-bonds, and at the same time provide a relatively large number of electrical connections using the relatively small diameter bond wires 630.

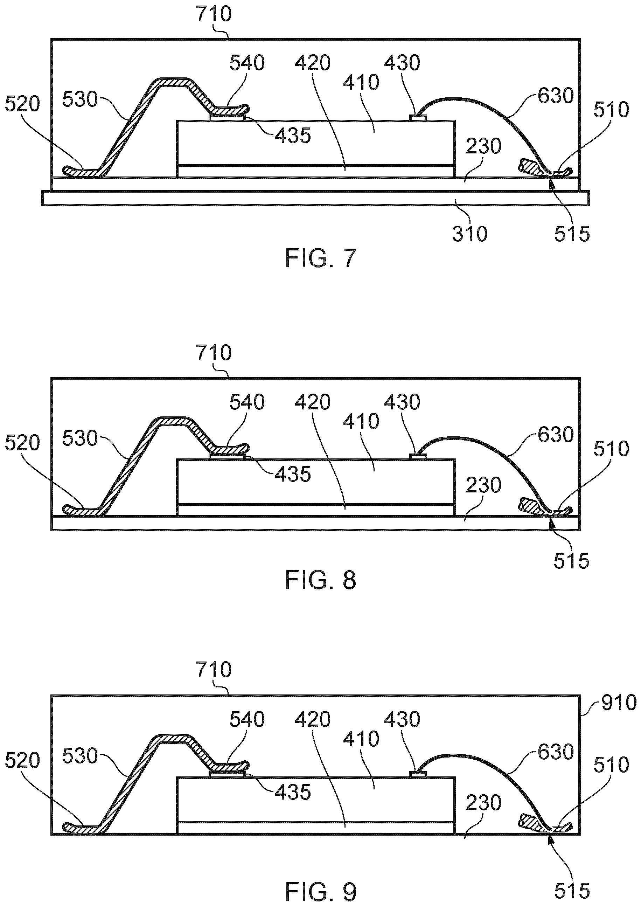

FIG. 7 shows a cross-section of a part assembled semiconductor package according to one or more embodiments during a still later stage of assembly. An encapsulant or molding compound 710 is introduced over the entire device in order to provide strength and environmental protection. As shown in FIG. 7, the molding compound 710 may be provided over a single device and in particular the final package may include just a single semiconductor die. However, the skilled person will appreciate that in other embodiments, a plurality of semiconductor die may be included in a single package, and in such embodiments, the encapsulant or molding compound 710 may be provided across the plurality of the die, eventually resulting in a single package. In yet other embodiments, a plurality of die may be bonded to a single substrate and carrier subassembly combination to provide a plurality of packages assembled on the carrier.

FIG. 8 shows a cross-section of a part assembled semiconductor package according to one or more embodiments during a yet later stage of assembly. As can be seen from the FIG., the carrier 310 has been removed. As described above, the substrate 230 may be relatively thin, in the case of a metal foil it may typically have a thickness between 0.01 mm and 0.05 mm. It will be appreciated that the substrate is not sufficiently robust to support the die, but since the die is now encapsulated in the molding compound 710, the assembly has sufficient strength and rigidity to no longer require the carrier 310. As also discussed above, the substrate 230 may be bonded to the carrier 310 by means of UV adhesive or similar. Separation of the substrate from the carrier may then be carried out for instance by exposure to UV light thereby softening the adhesive. Other suitable means of bonding the substrate to the carrier and subsequent removal thereof may be used.

FIG. 9 shows a cross-section of a part assembled semiconductor package according to one or more embodiments during a yet later stage of assembly. As can be seen from the FIG., the substrate 230 has been removed. This results in a packaged semiconductor device according to one or more embodiments of the present disclosure. In the device as shown in FIG. 9, the electrically conductive material or conductive epoxy 420 is exposed at a first major surface of the package, which are shown may be a bottom surface. Spaced apart therefrom, and separated therefrom by molding compound, are a plurality of solder pads 515 which comprise the exposed surface of the wedge-bonds 510 and 520. Wedge-bond stubs 510 are stand-alone short stubs of wedge-bond wire, which are encapsulated by the molding compound 710. They are electrically connected to the die contact pads by a respective ones of set of bond wires 630 which typically are formed from a thinner wire than the wedge-bonds. Use of a thinner wire facilitates bonding to the wedge-bond although the present disclosure is not limited thereto. Wedge-bonds 520 are integral to bond wires 530 which provide electrical connection between these solder pads and die contact pads 435.

The skilled person will appreciate that the present disclosure extends to embodiments in which includes only stand-alone wedge-bonds 510, or only integral wedge-bonds 520. Furthermore, embodiments may include one or more unconnected wedge-bonds 510 which are not electrically connected to the semiconductor die.

In embodiments, such as that shown in FIG 9, a single package is formed by the molding process. In such packages, the side faces of the packages, 910, may be formed by the inner surface of a molding tool used to inject molding compound to form the package, in methods which will be familiar to the skilled person.

Although a single package is shown in FIG. 9, In one or more other embodiments, a plurality of packages may be assembled on a single carrier 310 and substrate 230. In such embodiments, subsequent to removal of the carrier 310 and either subsequent to or prior to the removal of the substrate 230, individual packages may be singulated by means of saw cuts between them, or other suitable means.

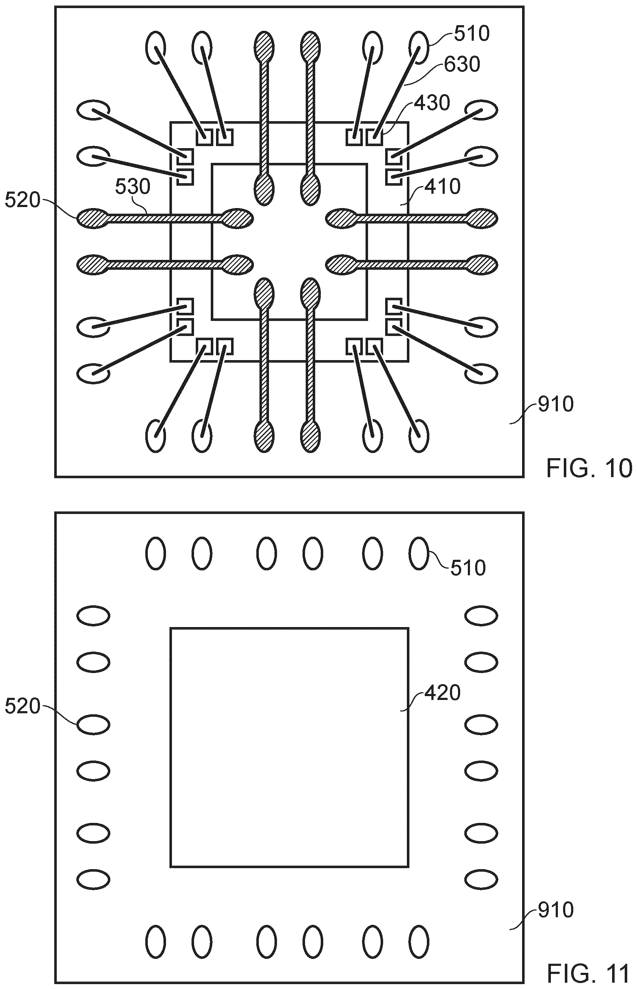

FIG. 10 shows a cut-away plan view of a package semiconductor device according to one or more embodiments, in which the molding compound has been partially removed (or rendered transparent). In the embodiment shown, the bond wires are combination of a first set of bond wires 630 comprising relatively thin wire material, and a second set of bond wires 530 comprising the wedge-bond wire. As shown, the semiconductor die may have a plurality of different subsets of contact pads, suitable for the first set of bond wires and the second set of bond wires respectively. They may be at different locations of the die (for instance the die contact pads for the wedge-bond wire may be further from the periphery). This may, for example, help to ensure that the integrity of the semiconductor die during bonding of the wedge-bond wire which may require additional force relative to the bonding of the first set of bond wires. Furthermore, typically the wedge bonding with the relatively thicker wire is done in the same process step as forming the wedge-bond stubs and thus prior to prior to the bonding of the relatively thinner wire. So for ease of access for the tool for the thinner wire, it may be preferred that the die contact pads for the thinner wire bonds are nearer to the periphery. In other embodiments, there may be a single set of die contact pads around the periphery of the semiconductor die. Other configurations will be familiar to the skilled person and fall within the scope of the present disclosure.

FIG. 11 shows a view of a second major surface of a package semiconductor device according to one or more embodiments. In the orientation of the FIG.s, the second major surface may be the bottom surface and the package may be considered to be viewed from below. The FIG. shows the exposed electrically conductive material or conductive epoxy 420 in a generally central region of the package. Around a generally peripheral area of the package are located a plurality of solder pads 510 and 520. Although, as will be apparent from hereinabove, the solder pads 510 correspond to the exposed surface of stand-alone wedge-bond stubs, and the solder pads 520 correspond to the exposed surface of wedge-bond wire which are integral to bond wires 530, this is not visible in the view of FIG. 11. Viewed from below, the package looks similar to a conventional packaged semiconductor device, except that the electrically conductive central region is comprised of an epoxy or other conductive material whereas in a conventional packaged semiconductor device, this region typically comprises a die pad or die paddle being part of a lead frame. Moreover, the packaged semiconductor device shown in FIG. 11 differs from conventional packaged semiconductor devices in the shape of the solder pads 510 and 520. Whereas in conventional devices, the solder pads are formed of the exposed lower surface of parts of the lead frame and their shape thus is typically generally rectangular, as shown in FIG. 11 the solder pads according to embodiments of the present disclosure are typically generally elliptical or rectangular with rounded corners and/or ends. As will be apparent from the disclosure, the shape of the exposed solder pads results from the degree of flattening of a - typically circular - bond wire which occurs during a wedge-bond.

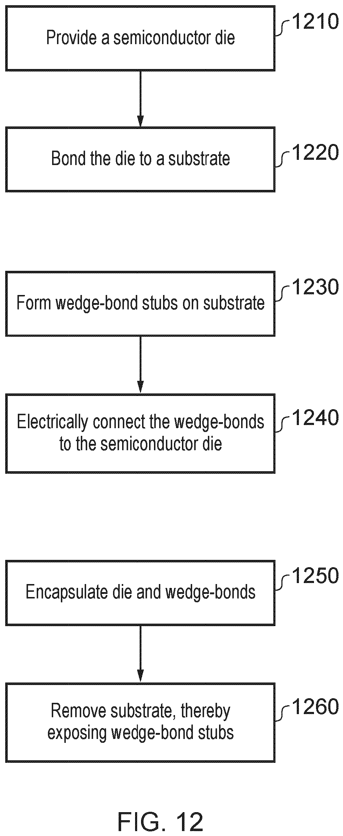

FIG. 12 shows a flowchart of a method according to one or more embodiments of the present disclosure. At 1210, a semiconductor die is provided. The semiconductor die may have a plurality of die contact pads on a first major die surface thereof. The first major die surface may correspond to a top surface of the die, which also may be referred to as an active surface of the die at or in which electrically active layers are provided which may provide electronic circuit elements such as transistors and diodes resistors and the like.

At 1220, the die is bonded to a substrate. In particular the second major surface of the semiconductor die may be bonded to a substrate for example by means of electrically conductive material or conductive epoxy or other suitable bonding means.

At 1230 wedge-bond stubs are formed on the substrate. The wedge-bond stubs may be formed from wedge-bond wire, and the lower surface of the wedge-bond - that is to say the surface which is bonded to the substrate, will, in the final device, be exposed to provide solder pads on a second major surface of the package and may correspond to a bottom surface.

At 1240, the wedge-bond stubs are electrically connected to the semiconductor die. As a result of the solder pads of the final package are electrically connected to the die contact pads. The electrical connection may be provided by a first set of bond wires or a second set of bond wires or a combination of the first set and second set of bond wires.

At 1250, the die is encapsulated. The encapsulation may be provided by injection molding a molding compound around the die and wedge-bonds. The encapsulation may be carried out at a single device level, or around a plurality of devices. In the latter case, the resulting encapsulation may comprise multiple packaged semiconductor devices, which may be singulated at a later stage of the process by means of sawcut or the like.

At 1260 the substrate is removed, thereby exposing the wedge-bond stubs. The exposed wedge-bonds and in particular the lower surface which is exposed may thereby act as solder pads for the package device, in place of the more conventionally used isolated parts of a lead frame.

According to one or more embodiments, the exposed surface of the wedge-bonds may be provided with with a flux or a plating to facilitate electrically connecting the package semiconductor device to a circuit board.

In one or more embodiments, the method further comprises: singulating the semiconductor device in the peripheral area of the second wedge-bond points and the bond areas. Optionally, the semiconductor device is an array of semiconductor devices, and the whole array needs to be divided into separate semiconductor devices. The scribing area is located in the peripheral area of the wedge-bond points, where the semiconductor devices can be divided.

Any range or device value given herein may be extended or altered without losing the effect sought, as will be apparent to the skilled person.

Although the invention has been described in the context of IC packages having a single die and a single electrical connector, it will be understood that the invention can be implemented in the context of IC packages having any suitable numbers of dies and any suitable numbers of electrical connectors.

Also, for purposes of this description, the terms "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

The use of FIG. numbers and/or FIG. reference labels in the claims is intended to identify one or more possible embodiments of the claimed subject matter in order to facilitate the interpretation of the claims. Such use is not to be construed as necessarily limiting the scope of those claims to the embodiments shown in the corresponding FIG.s.

Unless explicitly stated otherwise, each numerical value and range should be interpreted as being approximate as if the word "about" or "approximately" preceded the value or range.

It will be understood that various changes in the details, materials, and arrangements of the parts which have been described and illustrated in order to explain embodiments of this invention may be made by those skilled in the art without departing from embodiments of the invention encompassed by the following claims.

It should be understood that the steps of the exemplary methods set forth herein are not necessarily required to be performed in the order described, and the order of the steps of such methods should be understood to be merely exemplary. Likewise, additional steps may be included in such methods, and certain steps may be omitted or combined, in methods consistent with various embodiments of the invention.

Although the elements in the following method claims, if any, are recited in a particular sequence with corresponding labeling, unless the claim recitations otherwise imply a particular sequence for implementing some or all of those elements, those elements are not necessarily intended to be limited to being implemented in that particular sequence.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments necessarily mutually exclusive of other embodiments. The same applies to the term "implementation."

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

From reading the present disclosure, other variations and modifications will be apparent to the skilled person. Such variations and modifications may involve equivalent and other features which are already known in the art of packaging of semiconductor devices and which may be used instead of, or in addition to, features already described herein.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A packaged semiconductor device having a first major package surface and a second major package surface and comprising:
an encapsulated die having a plurality of die contact pads on a first major die surface thereof;
a molding compound; and
a plurality of exposed solder pads each comprising a flattened lower surface of wedge-bond stub;
wherein the plurality of exposed solder pads are around a peripheral region of the second major package surface and spaced apart by the molding compound; and
wherein the plurality of solder pads are electrically connected to the contact pads by at least one set of bond wires.

2. A packaged semiconductor device according to claim 1,
further comprising an exposed area of a conductive material in a central region of the second major package surface, electrically connected to a second die major surface, and spaced apart from the exposed solder pads by the molding compound.

3. A packaged semiconductor device according to claim 1 or 2,
wherein the at least one set of bond wires comprises a first set of bond wires each of which is bonded at a first end to a respective contact pad, and each of which comprises the wedge-bond stub at a respective second end.

4. A packaged semiconductor device according to claim 3,
wherein each of the first set of bond wires comprises the wedge-bond wire.

5. A packaged semiconductor device according to claim 4,
wherein the first set of bond wires comprises aluminum wires.

6. A packaged semiconductor device according to any preceding claim, wherein the at least one set of bond wires comprises a second set of bond wires each of which is bonded between a respective one of the plurality of die contact pads and a respective opposing surface to one of the exposed contact pads.

7. The packaged semiconductor device according to any preceding claim, wherein the wedge-bond wire comprises an aluminum wire.

8. The packaged semiconductor device according to any preceding claim,
further comprising at least one of a flux and a plating on a bottom surface of the exposed solder pads.

9. The packaged semiconductor device according to any preceding claim,
wherein a length of each exposed solder pad is in a range between 0.3 and 0.8mm, and a width of each exposed solder pad is in a range between 0.2 and 0.4mm.

10. The packaged semiconductor device according to any of claims 6 to 9,
wherein a diameter of each aluminum wire is in a range between 0.1 and 0.5mm.

11. A method of manufacturing a packaged semiconductor device having a first major package surface and a second major package surface,
the method comprising:
providing a semiconductor die having a plurality of die contact pads on a first major die surface thereof;
bonding a second major die surface of the semiconductor die to a substrate,
providing a plurality of solder pads each formed of a flattened lower surface of a wedge-bond stub around and remote from the semiconductor die by forming wedge-bonds on the substrate;
forming at least one set of electrical connections between the plurality of solder pads and the contact pads by a first set of bond wires;
encapsulating the semiconductor die and wedge-bond wire; and
removing the substrate, thereby exposing the solder pads on the second major package surface.

12. The method of claim 11,
wherein the step of bonding a second major die surface of the semiconductor die to a substrate comprises
bonding a second major die surface of the semiconductor die to a substrate by a conductive epoxy material,
and the step of removing the substrate comprises exposing the conductive epoxy material on the second major package surface.

13. The method of claim 11,
wherein forming at least one set of electrical connections comprises forming a plurality of wedge-bonds from the wedge-bond wires, between respective ones of the plurality of contact pads, and each of which comprises the wedge-bond stub at a respective second end.

14. The method of claim 13,
wherein each of the first set of bond wires comprises the wedge-bond wire.

15. The method of claim 13,
wherein the second set of bond wires comprises aluminum wires.
